# EUROPÄISCHE PATENTANMELDUNG

(11) **EP 1 600 528 A2**
(43) Veröffentlichungstag der Anmeldung: **30.11.2005**
(21) Anmeldenummer: 05009562.9
(22) Anmeldetag: 30.04.2005
(51) Int. Cl.: C25D 5/56

(54) **Verfahren zur Metallisierung von Kunststoffoberflächen**

(30) Priorität: 27.05.2004 DE 102004026489
(71) Anmelder: Enthone, Inc., West Haven, CT 06516 (US)
(72) Erfinder: Möbius, Andreas, Prof. Dr., 41564 Kaarst (DE); Hupe, Jürgen, Dr., 40764 Langenfeld (DE)
(74) Vertreter: Stenger, Watzke & Ring

(57) **Zusammenfassung**

Die vorliegende Erfindung betrifft ein Verfahren zur Metallisierung von Kunststopf-Oberflächen, wobei die Kunststoffoberflächen gebeizt, aktiviert und im Anschluß galvanisiert werden. Das erfindungsgemäße Verfahren ist durch einen Reduktionsschritt gekennzeichnet, in welchem die in Form von Sulfiden oder Polysulfiden vorliegenden Aktivatormetallkomplexe zum Metall reduziert werden. Hierdurch entsteht eine leitfähige Schicht auf welcher anschließend direkt elektrolytisch eine Metallschicht abgeschieden werden kann.

## Beschreibung

Die vorliegende Erfindung betrifft ein Verfahren zur Metallisierung von Kunststoffoberflächen, wobei die Kunststoffoberflächen gebeizt, aktiviert und im Anschluß galvanisiert werden.

Verfahren zur Direktmetallisierung von Kunststoffoberflächen sind aus dem Stand der Technik bekannt. Sie dienen dazu, den jeweiligen Kunststoff besondere verwendungsspezifische Eigenschaften zu verleihen. So werden zum Beispiel Kunststoffoberflächen zur Erzeugung eines dekorativen Aussehens metallisiert. In der Elektronikindustrie werden bei der Herstellung von integrierten Schaltkreisen Kunststoffsubstrate mit metallischen Leiterbahnen und Kontakten im Zuge einer Metallisierung ausgerüstet.

Bei den bekannten Verfahren wird die Kunststoffoberfläche zunächst gebeizt, um diese aufzurauhen beziehungsweise chemisch zu verändern. Dies kann beispielsweise mittels Mineralsäuren, Chromsäure, Chromschwefelsäure oder sauren beziehungsweise alkalischen Permanganatlösungen erfolgen. Weitere aus dem Stand der Technik bekannte Vorbehandlungsmethoden sind die Plasmabehandlung oder das Behandeln mit oxidierenden Beizen.

Durch den Beizvorgang wird die Kunststoffoberfläche derart aufgerauht beziehungsweise chemisch verändert, daß eine Haftung zwischen Kunststoff und Metallüberzug ermöglicht wird. Die gebeizten Kunststoffteile werden gespült und im Anschluß daran aktiviert. Im Stand der Technik sind unterschiedliche Methoden zur Aktivierung der Kunststoffoberflächen bekannt. So ist es beispielsweise bekannt, die Kunststoffoberflächen mit Edelmetallen wie beispielsweise kolloidalem Palladium, ionogenen Palladium oder Silberkollioden zu aktivieren. Darüber hinaus ist es bekannt, Metalle, die schwer lösliche Sulfide und Polysulfide bilden, als Aktivatoren für die Direktmetallisierung einzusetzen. Hierbei haben sich insbesondere Zinn, Blei, Silber, Bismut, Kobalt, Mangan und Kupfer als geeignet erwiesen.

Im Anschluß an die Aktivierung erfolgt entweder ein stromloses Metallisieren der Oberfläche zum Aufbau einer Leitschicht gefolgt von einem anschließenden elektrolytischen Schichtaufbau oder eine direkte chemische Metallabscheidung. Bei der Verwendung einer Palladium-Aktivierung erfolgt diese Metallabscheidung üblicherweise aus einem sauren Kupferbad, während bei der Verwendung von Sulfid- bzw. Polysulfidaktivatoren aus einem Nickelbad Metall abgeschieden wird.

So offenbart beispielsweise die Druckschrift EP 1 001 052 B1 ein Verfahren zur Metallisierung von Kunststoffoberflächen, bei welchem die Verfahrensschritte Beizbehandlung der Kunststoffoberfläche, Aktivierung der gebeizten Kunststoffoberfläche, behandeln der aktivierten Kunststoffoberfläche mit einer Sulfidlösung und anschließende Metallisierung der zu behandelnden Kunststoffoberfläche nacheinander stattfinden. Eine erste Metallabscheidung ist jedoch nur aus einem Elektrolyten mit einem negativen Abscheidungspotential, wie z.B. Nickel, möglich.

Mit Hilfe der so beschriebenen Verfahren ist eine Oberflächenmetallisierung einer Vielzahl von Kunststofftypen möglich. So lassen sich neben Acrylnitril-Butadien-Styrol (ABS) Kunststoffen auch andere Kunststoffe wie Polyacetate, Polysulfone, Polycarbonate, Polystyrole, Polyamide, Polypropylene oder Polyvinyloxide und deren Blends metallisieren.

Ein Nachteil der aus dem Stand der Technik bekannten gattungsgemäßen Metallisierungsverfahren ist, daß vor einer elektrolytischen Metallisierung auf dem Substrat eine leitfähige Schicht chemisch abgeschieden werden muß. Dies stellt einen zusätzlichen, in der Regel aufwendigen Arbeitsschritt dar. Eine direkte Metallisierung ist mit den aus dem Stand der Technik bekannten Verfahren nur bei ABS-Kunststoffen und unter Verwendung von Palladium-Aktivatoren möglich.

Unter Berücksichtigung des zuvor Ausgeführten liegt der vorliegenden Erfindung die **Aufgabe** zugrunde, ein Verfahren zur direkten elektrolytischen Metallisierung einer Vielzahl von Kunststoffen bereitzustellen, welches geeignet ist, die Nachteile der aus dem Stand der Technik bekannten Verfahren zu überwinden.

**Gelöst** wird diese Aufgabe erfindungsgemäß durch ein Verfahren zur Herstellung von Kunststoffoberflächen, aufweisend die Verfahrensschritte:
- Beizbehandlung einer Kunststoffoberfläche,
- in Kontakt bringen der Kunststoffoberfläche mit einer Metallsalz- und/oder Metallkomplexlösung aufweisend mindestens ein Metallsalz und/oder Metallkomplex eines Metalls der Gruppe bestehend aus Kobalt, Silber, Zinn, Blei, Bismut, Palladium, Kupfer, Nickel, Gold, Mangan, Zink und Eisen,
- in Kontakt bringen der behandelten Kunststoffoberfläche mit einer Sulfidlösung zur Bildung von Metallsulfidkomplexen auf der Oberfläche, und
- metallisieren der behandelten Kunststoffoberfläche in einem Metallisierungsbad,
welches dadurch gekennzeichnet ist, daß die auf der Kunststoffoberfläche befindlichen schwer löslichen Metallsulfide vor der Metallisierung in einem Reduktionsschritt zum Metall reduziert werden.

Durch die Reduktion der in Form von Sulfidkomplexen vorliegenden Metalle auf der Kunststoffoberfläche wird direkt eine leitfähige Metallschicht erhalten, welche ohne Aufmetallisierung einer zusätzlichen Leitschicht direkt elektrolytisch metallisiert werden kann.

Als besonders geeignete Aktivatormetalle erwiesen sich Kobalt, Silber, Zinn, Bismut und Blei. Jedoch zeigte sich das Verfahren auch für alle weiteren aus der Literatur bekannten Aktivatormetalle geeignet.

Vorteilhafterweise werden die Aktivatormetalle in Form ihrer Salze (wie zum Beispiel in Form ihrer Sulfate, Nitrate, Chloride, Methansulfonate oder Acetate) oder ihrer Komplexe (wie z.B. Amino-, Oxo-, Boro-, Oxalato-, Aquo- oder gemischte Komplexe) eingesetzt.

Als schwefelhaltige Verbindungen zur Darstellung von Sulfidkomplexen auf der Kunststoffoberfläche eignen sich insbesondere Natriumsulfid, Ammoniumsulfid oder Ammoniumpolysulfid, jedoch sind auch alle anderen Verbindungen, welche Sulfidkomplexe der eingesetzten Metalle beziehungsweise Metallsalze und Metallkomplexe bilden, erfindungsgemäß einsetzbar.

Die Aktivatormetalle werden in einer bevorzugten Ausführungsform nanoskalig abgeschieden. Nanoskalig bedeutet in diesem Zusammenhang, daß die auf der Kunststoffoberfläche abgeschiedenen Sulfidkomplexe eine Größe von 0,5 bis 500 nm, vorzugsweise 5 bis 100 nm aufweisen. Ausgangspunkt kann dabei eine nanoskalige Metallkomplexlösung sein. In einer weiteren Ausführungsform werden die Reaktionsbedingungen zwischen Metallsalzlösung und Sulfidlösung so eingestellt, dass nanoskalige Metallsulfide erhalten werden.

Die Reduktion der so erhaltenen nanoskaligen Metallsulfide führt zur Abscheidung nanoskaliger amorpher Metalle als erste Leitschicht auf der Kunststoffoberfläche.

Als Reduktionsmittel zur Reduktion der Aktivatormetall-Sulfidkomplexe eignen sich erfindungsgemäß z.B. Natriumhypophosphit, Dimethylaminoborat, Hydrazine, Hydrazinhydrat, Hydroxylammoniumsulfate, Sulfite oder Formiate.

Eine elektrochemische Reduktion der Metalle in den Sulfidkomplexen ist erfindungsgemäß gleichfalls möglich. Vorteilhafterweise erfolgt diese elektrochemische Reduktion in einem Basiselektrolyten, welcher keine abscheidbaren Metalle enthält. Ein solcher Basiselektrolyt ist zum Beispiel eine schwach saure Natriumsulfatlösung im pH-Bereich von 1 bis 7.

Das chemisch oder elektrochemisch reduzierte Aktivatormetall bildet somit eine leitfähige Metallschicht auf der Kunststoffoberfläche, welche ohne weitere Aufmetallisierung einer Hilfsschicht, direkt metallisiert werden kann, wobei neben Nickel auch Kupfer abgeschieden werden kann.

Eine erfindungsgemäß geeignete Beizlösung kann beispielsweise eine Mischung aus 400g/l Chromsäure und 400g/l Schwefelsäure aufweisen. Darüber hinaus sind Mischung im Verhältnis 10 bis 50 g/l Chromsäure zu 1000g/l Schwefelsäure erfindungsgemäß als Beizlösungen einsetzbar. Auch Mischungen von 0 bis 100 g/l Chromsäure zu 500 g/l Methansulfonsäure können erfindungsgemäß als Beizlösungen Verwendung finden.

Das nachfolgende Beispiel veranschaulicht das erfindungsgemäße Verfahren, ohne jedoch die Erfindung auf dieses Ausführungsbeispiel zu beschränken.

### Beispiel 1: Polyacetat (PA) und Polycarbonat (PC) Kunststoffe

Die zu metallisierende Kunststoffoberfläche wird mit einer klassischen Chromschwefelsäurebeize behandelt, so daß die Kunststoffoberfläche aufgeraut wird. An den Beizvorgang schließen sich die dazugehörigen Spülschritte an. Gegebenenfalls kann ferner ein Neutralisierungsschritt mit den dazugehörigen Spülschritten angeschlossen werden.

Nach dem Beizen bzw. dem Neutralisieren und den dazugehörigen Spülschritten wird das zu metallisierende Kunststoffteil in eine Lösung getaucht, um die Oberfläche vor der eigentlichen Aktivierung vorzubereiten und gewissermaßen vorzuaktivieren. Dafür wird das Werkstück in eine Lösung getaucht, welche 5 bis 10 g/l KMnO₄, 0,01 bis 0,1 g/l eines perfluorierten oder teilfluorierten Netzmittels, sowie 5 bis 15 g/l Natriumtetraborat enthält. Die Temperatur der Lösung liegt bei 30°C bis 50°C. Das Werkstück wird von der Lösung umspült, was entweder durch Bewegung des Bades und/oder durch die Bewegung des Werkstücks erzielt wird. Das zu metallisierende Kunststoffteil wird 4 bis 6 min in der Lösung getaucht, aber auch längere Tauchzeiten (bis zu 10 -15min) sind unschädlich und führen zu keiner nachteiligen Beschädigung der Kunststoffoberfläche.

Nach der Voraktivierung durch die oben beschriebene Lösung sowie den obligatorischen Spülschritten erfolgt die eigentliche Aktivierung. Diese kann durch die im Stand der Technik bekannten und hier nur beispielhaft aufgeführten Aktivierungsmethoden erfolgen. So kann die vorbehandelte und durch die Lösung chemisch veränderte Oberfläche mit Edelmetallaktivatoren oder mit den eingangs beschriebenen Metallkomplexen aktiviert werden. Gemäß Ausführungsbeispiel wird das zu metallisierende Werkstück für einen Zeitraum von 10 min in einer ammoniakalischen Lösung getaucht, welche 0,1 mol/l CoSO₄ enthält und einen pH-Wert von 10 sowie eine Temperatur von ca. 20°C aufweist. Im Anschluss daran werden die zu metallisierenden Kunststoffteile mit Wasser behandelt, welches mit einer Lauge wie NaOH bis zu einem pH-Wert von 13 alkalisch eingestellt wird. Im Anschluss daran erfolgt eine Behandlung mit einer Sulfidlösung, welche 0,01 Mol / I Na₂S₂ enthält. Nach der Aktivierung wird die so behandelte Kunststoffoberfläche mit einer Reduktionslösung der zuvor beschriebenen Art in Kontakt gebracht. Hierfür wird die zu metallisierende Kunststoffoberfläche in eine wässrige Lösung mit einem Hypophosphitgehalt von 25 g/l eingetaucht. Im Anschluss an die Reduktion erfolgt eine direkte galvanische Abscheidung von Kupfer aus einem sauren Elektrolyten wie z.B. Cuprostar 1530 der Firma Enthone.

### Beispiel 2: ABS/PC-Blends (85% PC-Anteil)

Die zu metallisierende Kunststoffoberfläche wird mit einer klassischen Chromschwefelsäurebeize behandelt, so daß die Kunststoffoberfläche aufgeraut wird. An den Beizvorgang schließen sich die dazugehörigen Spülschritte an. Gegebenenfalls kann ferner ein Neutralisierungsschritt mit den dazugehörigen Spülschritten angeschlossen werden.

Nach dem Beizen bzw. dem Neutralisieren und den dazugehörigen Spülschritten wird das zu metallisierende Kunststoffteil in eine Lösung getaucht, um die Oberfläche vor der eigentlichen Aktivierung vorzubereiten und gewissermaßen vorzuaktivieren. Dafür wird das Werkstück in eine Lösung getaucht, welche 5 bis 10 g/l KMnO₄, 0,01 bis 0,1 g/l eines perfluorierten oder teilfluorierten Netzmittels, sowie 5 bis 15 g/l Kaliumdihydrogenphosphat enthält. Die Temperatur der Lösung liegt bei 30°C bis 50°C. Das Werkstück wird von der Lösung umspült, was entweder durch Bewegung des Bades und/oder durch die Bewegung des Werkstücks erzielt wird. Das zu metallisierende Kunststoffteil wird 4 bis 6 min in der Lösung getaucht, aber auch längere Tauchzeiten (bis zu 10 -15min) sind unschädlich und führen zu keiner nachteiligen Beschädigung der Kunststoffoberfläche.

Nach der Voraktivierung durch die oben beschriebene Lösung sowie den obligatorischen Spülschritten erfolgt die eigentliche Aktivierung. Diese kann durch die im Stand der Technik bekannten und hier nur beispielhaft aufgeführten Aktivierungsmethoden erfolgen. So kann die vorbehandelte und durch die Lösung chemisch veränderte Oberfläche mit Edelmetallaktivatoren oder mit den eingangs beschriebenen Metallkomplexen aktiviert werden. Gemäß Ausführungsbeispiel wird das zu metallisierende Werkstück für einen Zeitraum von 5 Minuten in eine Pd/Sn Kolloidhaltige Lösung getaucht, welche 200 bis 250 mg/l Palladium, 10 g/l Zinn (II) und 110g/l HCL enthält und eine Temperatur von ca. 40°C aufweist. Im Anschluss daran werden die zu metallisierenden Kunststoffe gespült und ca. 4 Minuten in eine Lösung getaucht, die jeweils 10g/l einer Thioschwefelverbindung und einer Hydroxycarbonsäure enthält und eine Temperatur von ca. 55°C aufweist. Im Anschluss daran werden die auf der Oberfläche der zu metallisierenden Werkstücken befindlichen Metallsulfidkomplexe in einer mittels Schwefelsäure auf einen pH-Wert von 5 eingestellten Natriumsulfatlösung elektrolytisch Reduziert und es wird Kupfer direkt aus einem sauren Elektrolyten auf der zu metallisierenden Oberfläche abgeschieden.

### Beispiel 3: ABS/PC-Blends (85% PC-Anteil)

Die zu metallisierenden Kunststoffoberflächen werden wie in einer 1000 g/l Schwefelsäure gebeizt, die 30 g Chromsäure enthält. Im Anschluß an den Beizschritt werden die Oberflächen bei 25°C für 2 Min. mit einer wässrigen Lösung in Kontakt gebracht, welche Bismuthmethansulfonate (10 g/l Bi) enthält und deren pH-Wert mittels Methansulfonsäure auf unter 1 eingestellt wird. Nach diesem Behandlungsschritt wird die behandelte Kunststoffoberfläche zur Bildung von Bismutsulfiden auf der Oberfläche für 1 Min. mit einer 0,01 Mol / I Na₂S₂ Lösung in Kontakt gebracht. Die nach diesem Behandlungsschritt gebildeteten Bismuthsulfide werden wie in Beispiel 2 beschrieben elektrolytisch zum metallischen Bismuth reduziert. Auf den so behandelten Kunststoffoberflächen lässt sich direkt aus einem sauren Kupferelektrolyten der bekannten Art eine haftfeste Kupferschicht abscheiden.

Alternativ zur elektrolytischen Reduktion lassen sich die auf der Oberfläche gebildeten Bismutsulfide unter den in Beispiel 1 beschriebenen Bedingungen chemisch mittels Dimethylaminoboran zum Metall reduzieren.

## Patentansprüche

1. Verfahren zur Metallisierung von Kunststoffoberflächen, aufweisend die Verfahrensschritte
Beizbehandlung einer Kunststoffoberfläche,
in Kontakt bringen der Kunststoffoberfläche mit einer Metallsalz- und/oder Metallkomplexlösung aufweisend mindestens ein Metallsalz und/oder Metallkomplex eines Metalls der Gruppe bestehend aus Kobalt, Silber, Zinn, Blei, Bismut, Palladium, Kupfer, Nickel, Gold, Mangan, Zink oder Eisen,
in Kontakt bringen der behandelten Kunststoffoberfläche mit einer Sulfidlösung zur Bildung von Metallsulfidkomplexen auf der Kunststoffoberfläche, und
metallisieren der behandelten Kunststoffoberfläche in einem Metallisierungsbad, **dadurch gekennzeichnet, daß** die auf der Kunststoffoberfläche befindlichen Metallsulfide vor der Metallisierung in einem Reduktionsschritt zum Metall reduziert werden.

2. Verfahren gemäß Anspruch 1, **dadurch gekennzeichnet, daß** die Sulfidkomplexe chemisch reduziert werden.

3. Verfahren gemäß Anspruch 1, **dadurch gekennzeichnet, daß** die Sulfidkomplexe elektrochemisch in einem Basiselektrolyten reduziert werden, der keine abscheidbaren Metalle enthält.

4. Verfahren gemäß Anspruch 2, **dadurch gekennzeichnet, daß** als Reduktionsmittel Natriumhypophosphit, Dimethylaminoboran, Hydrazine, Hydrazinhydrat, Hydroxylammoniumsulfat, Sulfite, Formiate oder eine Mischung dieser eingesetzt wird.

5. Verfahren nach einem der vorhergehenden Ansprüche, **dadurch gekennzeichnet, daß** die Beizbehandlung mit einer sauren, wäßrigen Beizlösung, die Permanganat, Phosphorsäure, Methansulfonsäure, Chromsäure und/oder Schwefelsäure enthält, durchgeführt wird.

6. Verfahren nach einem der Ansprüche 1 bis 4, **dadurch gekennzeichnet, daß** die Beizbehandlung in einer wäßrigen, alkalischen, permanganathaltigen Beizlösung durchgeführt wird.

7. Verfahren nach einem der vorhergehenden Ansprüche, **dadurch gekennzeichnet, daß** als Sulfidkomplexe bildende schwefelhaltige Verbindung in der Sulfidlösung eine Verbindung der Gruppe bestehend aus Natriumsulfid, Ammoniumsulfid und Ammoniumpolysulfid oder eine Mischung dieser eingesetzt wird.

8. Verfahren nach einem der vorhergehenden Ansprüche, **dadurch gekennzeichnet, dass** die Aktivatormetallkomplexe und -sulfid auf der Kunststoffoberfläche nanoskalige abgeschieden werden.
